# EUROPEAN PATENT SPECIFICATION

(11) **EP 2 891 515 B1**
(45) Date of publication and mention of the grant of the patent: **03.06.2020**
(21) Application number: 14186042.9
(22) Date of filing: 23.09.2014
(51) Int. Cl.: B01D 67/00, B01D 71/56, B01D 69/06, B01D 69/02, B01D 71/68

(54) **MEMBRANE WITH ZONES OF DIFFERENT CHARGE**
MEMBRAN MIT ZONEN VERSCHIEDENER LADUNG
MEMBRANE AVEC DES ZONES DE CHARGE DIFFÉRENT

(30) Priority: 06.01.2014 US 201414147971
(43) Date of publication of application: 08.07.2015
(73) Proprietor: Pall Corporation, Port Washington, NY 11050 (US)
(72) Inventor: Singh, Amarnauth, Selden, NY New York 11784 (US); Wang, I-Fan, San Diego, CA California 92128 (US)
(74) Representative: Hoeger, Stellrecht & Partner Patentanwälte mbB

(56) References cited:
- EP-A1- 2 604 329
- WO-A1-02/11868
- WO-A1-85/03012
- WO-A1-2013/039456
- US-A- 4 097 383
- US-A- 4 250 029
- US-A- 4 673 504
- US-A1- 2006 016 685

## Description

### BACKGROUND OF THE INVENTION

Charge mosaic membranes and/or membranes comprising multiple layers, the layers having different charges (e.g., positive charge layer, negative charge layer) are used in a variety of applications.

However, there is a need for improved membranes having a plurality of charges.

The present invention provides for ameliorating at least some of the disadvantages of the prior art. These and other advantages of the present invention will be apparent from the description as set forth below.

US patent US 4,250,029 discloses membranes having two or more coatings of polyelectrolytes with at least one oppositely charged adjacent pair of coatings separated by a neutral layer to reduce charge neutralization. It further discloses a method of preparing the membranes and the use for rejecting ionically charged solutes.

WO 02/11868A1 relates to an at least two zone, unsupported, continuous microporous membrane. The at least two zone, unsupported, continuous microporous membrane includes at least two different membrane pore size zones or the pore sizes may be about the same size. The process disclosed for making the membrane comprises the steps of applying polymer dopes from dope feed slots onto a continuously moving coating surface so as to create a multiple layer polymer dope coating on the coating surface, subjecting the multiple dope zone layer in contact with a phase inversion producing environment so as to form a wet multizone phase inversion microporous membrane, and then washing and drying the membrane.

### BRIEF SUMMARY OF THE INVENTION

The present invention relates to a microporous membrane as set out in claims 1 and 2. The invention further relates to a method of treating a fluid as defined in claim 11.

The membrane can be asymmetric, or isometric.

In an embodiment, the first microporous surface comprises a first region and a second region, and the distance between the first region of the first microporous surface and the second microporous surface is at least about 10 percent greater than the distance between the second region of the first microporous surface and the second microporous surface, and in some embodiments, the membrane has localized asymmetries.

In other embodiments, methods of processing fluids by passing the fluids through the membranes, are provided.

### BRIEF DESCRIPTION OF THE SEVERAL VIEWS OF THE DRAWING(S)

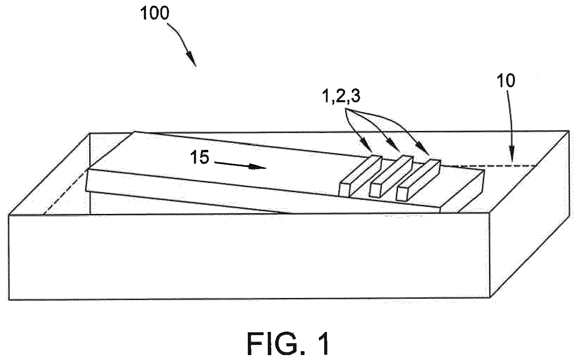

Figure 1 is a generalized diagrammatic illustration showing a system for preparing a membrane according to an embodiment of the invention.

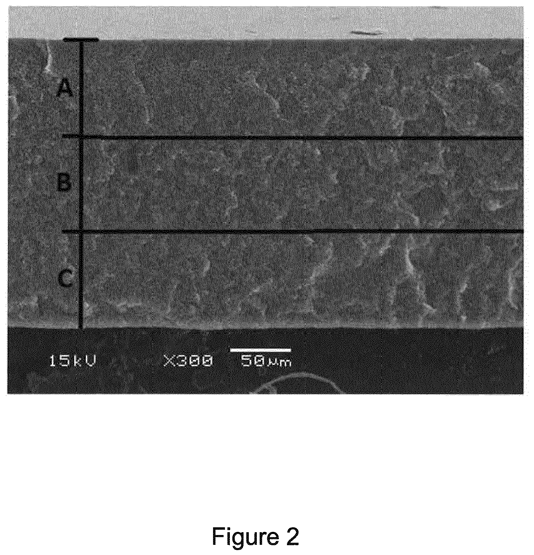

Figure 2 is a scanning electron micrograph (SEM) showing a cross-sectional view of embodiment of an asymmetric non-templated membrane according to the present invention, having first and second microporous surfaces, and a bulk between the surfaces, the bulk having a first charge continuous zone, a neutral charge continuous zone, and a second charge continuous zone, the continuous zones arranged generally parallel to the first and second microporous surfaces, wherein the neutral continuous zone is interposed between the first charge continuous zone and the second charge continuous zone, and wherein the first charge continuous zone and the second charge continuous zone have opposing charges.

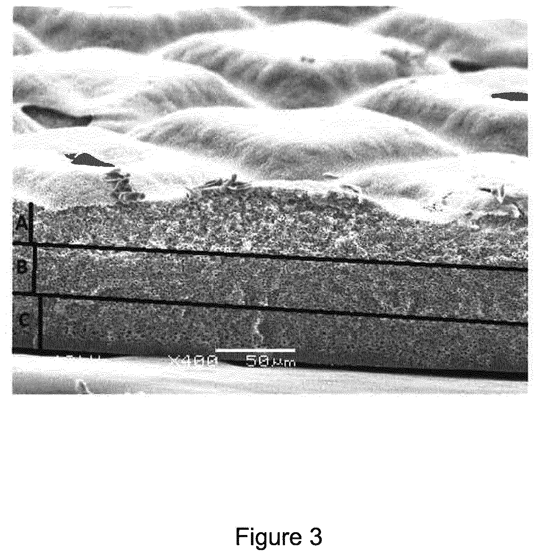

Figure 3 is an SEM showing a cross-sectional view of embodiment of an asymmetric templated membrane according to the present invention, wherein the membrane has a first microporous surface having at least a first region and a second region, and a second microporous surface, wherein the distance between the first region of the first microporous surface and the second microporous surface is at least about 10 percent greater than the distance between the second region of the first microporous surface and the second microporous surface. Additionally, the membrane has a portion where the positively charged continuous zone contacts the neutral charge continuous zone, and a portion where the negatively charged continuous zone contacts the neutral continuous zone, wherein the portions are arranged generally parallel to each other.

### DETAILED DESCRIPTION OF THE INVENTION

In accordance with an embodiment of the present invention, a microporous membrane is provided, the membrane comprising (a) a single layer having (i) a first microporous surface; (ii) a second microporous surface; and, (iii) a bulk between the first microporous surface and the second microporous surface, wherein the bulk has a first charge continuous zone, a neutral charge continuous zone, and a second charge continuous zone, the continuous zones arranged generally parallel to the first and second microporous surfaces, wherein the neutral continuous zone is interposed between the first charge continuous zone and the second charge continuous zone, and wherein the first charge continuous zone and the second charge continuous zone have opposing charges.

In another embodiment, a microporous membrane is provided, the membrane comprising a single layer having (i) a first microporous surface; (ii) a second microporous surface; and, (iii) a bulk between the first microporous surface and the second microporous surface, wherein the bulk has a first charge continuous zone, a neutral charge continuous zone, and a second charge continuous zone, wherein the neutral continuous zone is interposed between the first charge continuous zone and the second charge continuous zone, and wherein the first charge continuous zone and the second charge continuous zone have opposing charges, the membrane having a portion where the first charge continuous zone contacts the neutral continuous zone, and a portion where the second charge continuous zone contacts the neutral continuous zone, wherein the portions are arranged generally parallel to each other. In an embodiment, the continuous zones are arranged generally parallel to the first and second microporous surfaces.

Asymmetric and isometric membranes are provided in accordance with the invention.

In a "templated" embodiment of the membrane, the first microporous surface comprises a first region and a second region, and the distance between the first region of the first microporous surface and the second microporous surface is at least about 10 percent greater (in some embodiments, at least about 15% greater) than the distance between the second region of the first microporous surface and the second microporous surface.

In some embodiments, e.g., wherein the membrane has at least one patterned or textured surface (a "templated surface"), wherein the membrane has a first microporous surface comprising a first region and a second region, the first microporous surface has a predetermined pattern comprising the first region and the second region.

In accordance with embodiments of the invention, fluid to be processed can contact the positively charged zone before the neutral zone and the negatively charged zone, or the fluid to be treated can contact the negatively charged zone before the neutral zone and the positively charged zone.

For example, in some embodiments, wherein the first microporous surface provides the upstream surface of the membrane, the first charge continuous zone extends from the first microporous surface into the bulk, and the first charge continuous zone is a positively charged zone, and the second charge continuous zone extends from the second microporous surface into the bulk, and the second charge continuous zone is a negatively charged zone.

In some other embodiments, wherein the first microporous surface provides the upstream surface of the membrane, the first charge continuous zone extends from the first microporous surface into the bulk, and the first charge continuous zone is a negatively charged zone, and the second charge continuous zone extends from the second microporous surface into the bulk, and the second charge continuous zone is a positively charged zone.

In another embodiment, a method of processing a fluid is provided, comprising passing a fluid through an embodiment of the membrane, e.g., from the first microporous surface and through the bulk and the second microporous surface. In those embodiments wherein the membrane has a templated surface, embodiments of the method can comprise passing a fluid from the first microporous surface comprising a templated surface and through the bulk and the second microporous surface, or comprise passing the fluid from the non-templated microporous surface through the bulk and through the templated microporous surface.

In another embodiment, a filter device is provided, comprising the membrane disposed in a housing comprising at least one inlet and at least one outlet and defining at least one fluid flow path between the inlet and the outlet, wherein the membrane is across the fluid flow path. In one embodiment, the filter device comprises a housing comprising at least one inlet and at least a first outlet and a second outlet, and defining first fluid flow path between the inlet and the first outlet, and a second fluid flow path between the inlet and the second outlet, wherein the filter is across the first fluid flow path, e.g., allowing tangential flow such that the first liquid passes along the first fluid flow path from the inlet through the filter and through the first outlet, and the second fluid passes along the second fluid flow path from the inlet and through the second outlet without passing through the filter.

A method of making a membrane according to an embodiment of the invention comprises (a) preparing a polymeric solution comprising a positive charge; (b) preparing a polymeric solution comprising a neutral charge; (c) preparing a polymeric solution comprising a negative charge; (d) casting the solutions sequentially on a moving support, wherein (i) either the polymeric solution comprising the positive charge, or the polymeric solution comprising the negative charge, is cast first, forming a pre-membrane; (ii) the polymeric solution comprising the neutral charge is cast second, onto the pre-membrane; (iii) the polymeric solution that is not cast in (a) is cast third, onto the polymeric solution comprising the neutral charge; and, (e) effecting phase separation of the solutions in a nonsolvent liquid.

In another embodiment, a method of making a membrane comprising a templated surface comprises (a) obtaining a template (e.g., a template having a predetermined pattern or geometry such as an embossed template); (b) sequentially casting polymer solutions comprising positive, neutral, and negative charges over the template, wherein (i) either the polymeric solution comprising the positive charge, or the polymeric solution comprising the negative charge, is cast first; (ii) the polymeric solution comprising the neutral charge is cast second; (iii) the polymeric solution that is not cast in (a) is cast third; (c) precipitating the cast polymer solutions to provide a membrane; and (d) separating the membrane from the template.

Advantageously, a plurality of charges can be provided in a single membrane layer, avoiding the risk of delamination of layers. In some applications, a membrane having reduced thickness, as compared to multiple layer membranes, can be provided.

In contrast to charge mosaic membranes, the location of the charges can be controlled more efficiently, allowing membranes to be tailored for particular fluid processing (e.g., filtration) applications.

Membranes according to embodiments of the invention can be used in a variety of applications, including, for example, diagnostic applications (including, for example, sample preparation and/or diagnostic lateral flow devices), ink jet applications, filtering fluids for the pharmaceutical industry, filtering fluids for medical applications (including for home and/or for patient use, e.g., intravenous applications, also including, for example, filtering biological fluids such as blood (e.g., to remove leukocytes)), filtering fluids for the electronics industry (e.g., filtering photoresist fluids in the microelectronics industry), filtering fluids for the food and beverage industry, clarification, filtering antibody- and/or protein-containing fluids, filtering nucleic acid-containing fluids, cell detection (including *in situ*), cell harvesting, and/or filtering cell culture fluids. Alternatively, or additionally, membranes according to embodiments of the invention can be used to filter air and/or gas and/or can be used for venting applications (e.g., allowing air and/or gas, but not liquid, to pass therethrough). Membranes according to embodiments of the inventions can be used in a variety of devices, including surgical devices and products, such as, for example, ophthalmic surgical products.

In one embodiment wherein the upstream portion of the membrane comprises a positively charged continuous zone and the downstream portion of the membrane comprises a negatively charged continuous zone, a method of treating fluid comprises passing a fluid comprising a higher concentration of anions than cations from the upstream surface of the membrane through the downstream surface. Without being limited to any particular mechanism, it is believed that as the anions are captured and/or bound in the positively charged continuous zone, the anions can repulse some additional anions, providing a prefiltration function, and allowing more of the positively charged continuous zone to be available for further adsorption to capacity.

Similarly, in one embodiment wherein the upstream portion of the membrane comprises a negatively charged continuous zone and the downstream portion of the membrane comprises a positively charged continuous zone, a method of treating fluid comprises passing a fluid comprising a higher concentration of cations than anions from the upstream surface of the membrane through the downstream surface. Without being limited to any particular mechanism, it is believed that as the cations are captured and/or bound in the negatively charged continuous zone, the cations can repulse some additional cations, providing a prefiltration function, and allowing more of the negatively charged continuous zone to be available for further adsorption to capacity.

In some embodiments of the templated membranes, having an upstream templated surface surface provides increased surface area, and thus, an increased capacity for anions or cations.

A variety of fluids can be treated, e.g., filtered, in accordance with embodiments of the invention. In an embodiment of filtering fluids for the electronics industry, e.g., for the microelectronics industry, a photoresist fluid is passed through an embodiment of a membrane according to the invention. For example, the photoresist fluid can have a higher concentration of anions than cations, and the method can comprise passing the fluid from the upstream portion of a membrane comprising the positively charged continuous zone, through the neutral continuous zone, and through the downstream portion of the membrane comprising the negatively charged continuous zone.

An asymmetric membrane or section has a pore structure (for example, a mean pore size) varying throughout the section. Typically, the mean pore size decreases in size from one portion or surface to another portion or surface (e.g., the mean pore size decreases from the upstream portion or surface to the downstream portion or surface). However, other types of asymmetry are encompassed by embodiments of the invention, e.g., the pore size goes through a minimum pore size at a position within the thickness of the asymmetric section (e.g., a portion of an asymmetric section can have an "hourglass-type" pore structure). An asymmetric section can have any suitable pore size gradient or ratio, e.g, about 3 or more, or about 7 or more. This asymmetry can be measured by comparing the mean pore size on one major surface of a section with the mean pore size of the other major surface of that section.

The following definitions are used in accordance with the invention.

In accordance with the invention, opposing charges refers to positive charge and negative charge. Opposing charges do not require equal charge densities, e.g., the positively charged continuous zone can have a greater charge density (e.g., it can be "more" positively charged) than the charge density of the negatively charged continuous zone.

In accordance with the invention, a charge continuous zone refers to a charge localized in a generally predetermined portion of the thickness of the membrane, generally parallel to the major surfaces (upstream and downstream surfaces) of the membrane. In contrast, mosaic membranes have a plurality of separate (non-continuous) anion-exchange regions, cation-exchange regions, and neutral regions throughout the membrane.

The membranes can have any suitable pore structures, e.g., pore sizes (for example, as evidenced by bubble point, or by K_{L} as described in, for example, U.S. Patent 4,340,479, or evidenced by capillary condensation flow porometry), average pore size (e.g., determined by using a scanning electron microscope to magnify a membrane's cross-sectional view and measuring a set of pores using software), mean flow pore (MFP) sizes (e.g., when characterized using a porometer, for example, a Porvair Porometer (Porvair plc, Norfolk, UK), or a porometer available under the trademark POROLUX
(Porometer.com; Belgium)), pore ratings (e.g., using a surrogate solution with particles such as beads), pore diameters (e.g., when characterized using the modified OSU F2 test as described in, for example, U.S. Patent 4,925,572), or removal ratings that reduce or allow the passage therethrough of one or more materials of interest as the fluid is passed through the membranes. The pore structures provided depend on, fopr example, the composition of the fluid to be treated, and the desired effluent level of the treated fluid.

Typically, membranes according to embodiments of the invention have a thickness in the range of from about 70 µm to about 400 µm.

Preferably, the membrane is prepared by a thermally induced phase inversion process. Typically, the phase inversion process involves casting or extruding polymer solution(s) into thin films, and precipitating the polymers through one or more of the following: (a) evaporation of the solvent and nonsolvent, (b) exposure to a non-solvent vapor, such as water vapor, which absorbs on the exposed surface, (c) quenching in a non-solvent liquid (e.g., a phase immersion bath containing water, and/or another non-solvent), and (d) thermally quenching a hot film so that the solubility of the polymer is suddenly greatly reduced. Phase inversion can be induced by the wet process (immersion precipitation), vapor induced phase separation (VIPS), thermally induced phase separation (TIPS), quenching, dry-wet casting, and solvent evaporation (dry casting). Dry phase inversion differs from the wet or dry-wet procedure by the absence of immersion coagulation. In these techniques, an initially homogeneous polymer solution becomes thermodynamically unstable due to different external effects, and induces phase separation into a polymer lean phase and a polymer rich phase. The polymer rich phase forms the matrix of the membrane, and the polymer lean phase, having increased levels of solvents and non-solvents, forms the pores.

The membranes can be cast manually (e.g., poured, cast, or spread by hand onto a casting surface) or automatically (e.g., poured or otherwise cast onto a moving bed). Examples of suitable supports include, for example, polyethylene coated paper, or polyester (such as MYLAR), a belt such as a stainless steel belt, or an embossed substrate.

A variety of casting techniques, including multiple casting techniques, are known in the art and are suitable. A variety of devices known in the art can be used for casting. Suitable devices include, for example, mechanical spreaders, that comprise spreading knives, doctor blades, or spray/pressurized systems. One example of a spreading device is an extrusion die or slot coater, comprising a casting chamber into which the casting formulation (solution comprising a polymer) can be introduced and forced out under pressure through a narrow slot. Illustratively, the solutions comprising polymers can be cast by means of a doctor blade with knife gaps in the range from about 100 micrometers to about 500 micrometers, more typically in the range from about 120 micrometers to about 400 micrometers.

A variety of casting speeds for producing membranes according to the invention are suitable as is known in the art. Typically, the casting speed is at least about 3 feet per minute (fpm), more typically in the range of from about 3 to about 15 fpm, in some embodiments, at least about 7 fpm.

Suitable polymer solutions are polysulfones, including aromatic polysulfones such as, for example, polyethersulfone, polyether ether sulfone, bisphenol A polysulfone, polyarylsulfone, and polyphenylsulfones or polyamides.

In addition the polymer solutions comprise at least one solvent, and may further comprise at least one non-solvent. Suitable solvents include, for example, dimethyl formamide (DMF); N,N-dimethylacetamide (DMAc); N-methyl pyrrolidone (NMP); dimethyl sulfoxide (DMSO), methyl sulfoxide, tetramethylurea; dioxane; diethyl succinate; chloroform; and tetrachloroethane; and mixtures thereof. Suitable nonsolvents include, for example, water; various polyethylene glycols (PEGs; e.g., PEG-200, PEG-300, PEG-400, PEG-1000); various polypropylene glycols; various alcohols, e.g., methanol, ethanol, isopropyl alcohol (IPA), amyl alcohols, hexanols, heptanols, and octanols; alkanes, such as hexane, propane, nitropropane, heptanes, and octane; and ketone, ethers and esters such as acetone, butyl ether, ethyl acetate, and amyl acetate; and various salts, such as calcium chloride, magnesium chloride, and lithium chloride; and mixtures thereof.

If desired, a solution comprising a polymer can further comprise, for example, one or more polymerization initiators (e.g., any one or more of peroxides, ammonium persulfate, aliphatic azo compounds (e.g., 2,2'-azobis(2-amidinopropane) dihydrochloride (V50)), and combinations thereof), and/or minor ingredients such as surfactants and/or release agents.

Suitable components of solutions are known in the art. Illustrative solutions comprising polymers, and illustrative solvents and nonsolvents include those disclosed in, for example, U.S. Patents 4,340,579; 4,629,563; 4,900,449; 4,964,990, 5,444,097; 5,846,422; 5,906,742; 5,928,774; 6,045,899; 6,146,747; and 7,208,200.

In those embodiments wherein the membrane has a first microporous surface comprising at least a first region and a second region, and (i) the distance between the first region of the first microporous surface and the second microporous surface is at least about 10 percent greater than the distance between the second region of the first microporous surface and the second microporous surface and/or (ii) the membrane has at least one patterned or textured surface, wherein the membrane has a first microporous surface comprising a first region and a second region, the first microporous surface has a predetermined pattern comprising the first region and the second region, the membrane can preferably be produced by either (a) obtaining a template (e.g., having a pattern or predetermined geometry such as an embossed template); (b) sequentially casting polymer solutions comprising positive, neutral, and negative charges over the template, wherein (i) either the polymeric solution comprising the positive charge, or the polymeric solution comprising the negative charge, is cast first; (ii) the polymeric solution comprising the neutral charge is cast second; (iii) the polymeric solution that is not cast in (a) is cast third; (c) precipitating the cast polymer solutions to provide a membrane; and (d) separating the membrane from the template.

A variety of materials are suitable for use as templates, for example, the template (which can be hydrophilic or hydrophobic) can be made of a fabric (woven or non-woven), embossed foil, metal screen, extruded mesh, textured rubber, embossed polymer film, and various polymer materials. In preferred embodiments, the templates have openings passing from one surface to another, particularly templates comprising open meshes.

If desired, there are a number of procedures for confirming the presence of the desired zones in the membranes. For example, dye screening tests can be carried out using charged dyes, for example, positively charged dyes such as polyethylenimine (PEI) or toluidine blue, and negatively charged dyes such as 2-acrylamido-2-methylpropane sulfonic acid (AMPS) or Ponseau S red. Alternatively, or additionally, the zeta potentials can be determined, e.g., by determining streaming potentials at various pHs.

The membrane can have any desired critical wetting surface tension (CWST, as defined in, for example, U.S. Patent 4,925,572). The CWST can be selected as is known in the art, e.g., as additionally disclosed in, for example, U.S. Patents 5,152,905, 5,443,743, 5,472,621, and 6,074,869. In some embodiments, the membrane is hydrophilic, having a CWST of 72 dynes/cm (72 x 10⁻⁵ N/cm) or more. In some embodiments, the membrane has a CWST of 75 dynes/cm (about 75 x 10⁻⁵ N/cm) or more.

The surface characteristics of the membrane can be modified (e.g., to affect the CWST, to include a surface charge, e.g., a positive or negative charge, and/or to alter the polarity or hydrophilicity of the surface) by wet or dry oxidation, by coating or depositing a polymer on the surface, or by a grafting reaction. Modifications include, e.g., irradiation, a polar or charged monomer, coating and/or curing the surface with a charged polymer, and carrying out chemical modification to attach functional groups on the surface. Grafting reactions may be activated by exposure to an energy source such as gas plasma, vapor plasma, corona discharge, heat, a Van der Graff generator, ultraviolet light, electron beam, or to various other forms of radiation, or by surface etching or deposition using a plasma treatment.

Additionally, or alternatively, the membrane can include, e.g., throughout the membrane or in a portion of the membrane (for example, a zone of the membrane) at least one component for providing one or more desired functions and/or characteristics to the resultant membrane, e.g., one or more of the following: a solid such as, for example, sodium bicarbonate or sodium chloride (e.g., that may be leached out resulting in a pore); a component for providing an antimicrobial function, such as a bacteriostatic or bacteriocidal function (for example, by including a silver-based reagent, e.g., silver nitrate); providing a charge such as a negative charge (e.g., for adsorbing negatively charged target entities such as bacteria, mammalian cells, free nucleic acids, proteins (under certain pH environments) and drugs such as heparin); a positive charge (e.g., for adsorbing positively charged target entities such as proteins (under certain pH environments) and drugs such as dopamine); a zwitterion; and a mixed charge; providing a chelation function (e.g., by including a chelating polymer such as polyacrylic acid, polyvinylsulfonic acid, and sulfonated polystyrene, for example, for adsorbing heavy metals); including a denrimer (e.g., polyamidoamine (PAMAM) for binding pharmaceutically active compounds, including drug metabolites from blood samples); including liposomes (e.g., for carrying/delivering a desired material such as a drug, for example, providing a membrane-based medicinal skin patch); and including a functionalized bead and/or sorbent such as a chromatography sorbent, an affinity sorbet (such as antibodies, antibody fragments, enzymes, e.g., for adsorbing targets such as proteins and/or endotoxins), an activated sorbent (such as activated carbon, activated silica, and activated alumina). Advantageously, by including the component(s) as part of one portion (e.g., zone), the desired function(s) and/or characteristic(s) can be provided, if desired, to a desired portion and/or side of the membrane, rather than throughout the entire membrane. For example, the desired function(s) and/or characteristic(s) can be localized to the portion of the membrane first contacted by the fluid to be treated, or, for example, the portion of the membrane first contacted by the fluid to be treated can have a higher concentration of the desired function(s) or characteristic(s) than the other portions of the membrane surface facing the fluid to be treated. Additionally, for example, a casting solution can be used to provide a membrane with one or more desired functions and/or characteristics.

In those embodiments of the invention comprising a filter comprising at least one filter element comprising at least one membrane according to the invention, the filter can include additional elements, layers, or components, that can have different structures and/or functions, e.g., at least one of prefiltration, support, drainage, spacing and cushioning. Illustratively, the filter can also include at least one additional element such as a mesh and/or a screen.

The present invention further provides a device, e.g., a filter device, chromatography device and/or a membrane module comprising one or more membranes of the present invention disposed in a housing. The device can be in any suitable form. For example, the device can include a filter element comprising the membrane in a substantially planar, pleated, or spiral form. In an embodiment, the element can have a hollow generally cylindrical form. If desired, the device can include the filter element in combination with upstream and/or downstream support or drainage layers. The device can include a plurality of membranes, e.g., to provide a multilayered filter element, or stacked to provide a membrane module, such as a membrane module for use in membrane chromatography.

The filter, in some embodiments comprising a plurality of filter elements, is typically disposed in a housing comprising at least one inlet and at least one outlet and defining at least one fluid flow path between the inlet and the outlet, wherein the filter is across the fluid flow path, to provide a filter device. In another embodiment, the filter device comprises a housing comprising at least one inlet and at least a first outlet and a second outlet, and defining first fluid flow path between the inlet and the first outlet, and a second fluid flow path between the inlet and the second outlet, wherein the filter is across the first fluid flow path, e.g., allowing tangential flow such that the first liquid passes along the first fluid flow path from the inlet through the filter and through the first outlet, and the second fluid passes along the second fluid flow path from the inlet and through the second outlet without passing through the filter. Filter cartridges can be constructed by including a housing and endcaps to provide fluid seal as well as at least one inlet and at least one outlet.

In some embodiments, the filter device is sterilizable. Any housing of suitable shape and providing at least one inlet and at least one outlet may be employed. The housing can be fabricated from any suitable rigid impervious material, including any impervious thermoplastic material, which is compatible with the biological fluid being processed. For example, the housing can be fabricated from a metal, such as stainless steel, or from a polymer. In an embodiment, the housing is a polymer, in some embodiments, a transparent or translucent polymer, such as an acrylic, polypropylene, polystyrene, or a polycarbonated resin. Such a housing is easily and economically fabricated, and allows observation of the passage of the fluid through the housing.

The following examples further illustrate the invention.

In the following Examples, membranes are produced using a system 100 arranged as generally shown in Figure 1, wherein solutions are cast on a moving support (in the casting direction 15) moving toward knives 1, 2, and 3, and the precipitation bath level is represented by the dotted line 10.

The casting solutions are described in the respective examples, and the charge continuous zones are produced without using charged particles. Membranes are cast onto a MYLAR film support (Examples 1-5) or an embossed polypropylene template (Examples 6 and 7) at a casting speed of 5 ft/min, using casting 3 casting knifes (knives 1-3), wherein the knives are used at preset air gaps of 5 inches apart each, and thickness gaps of 10, 20, and 30 mil, respectively. Following casting, the membranes are quenched in a bath until the membrane is coagulated. The membranes are removed from the support, further washed with deionized water, and oven dried.

### EXAMPLE 1

This example demonstrates the preparation and describes the structure of an isometric microporous nylon membrane with charged continuous zones according to an embodiment of the invention, wherein the upstream zone has a positively charged continuous zone.

Three solutions (A, B, and C) are prepared. Solution A (positive charge) consists of 13% Nylon, 11% deiononized (DI) water, 1% Kymene, and 75% Formic Acid. Solution B (neutral charge) consists of 13% Nylon, 12% DI water, and 75% Formic Acid. Solution C (negative charge) consists of 13% Nylon, 11% DI water, 1% Gantrez, and 75% Formic Acid. The solutions are dissolved at 40 °C and deaerated before casting. Solutions A, B, and C are placed in knives 1, 2, and 3, respectively. Following casting, the membranes are quenched in a bath (1:1 mix of formic acid to DI water at room temperature) for about 6 minutes until the membrane is coagulated.

The membrane is about 125 µm in thickness, wherein each zone is about 35 µm to about 45 µm in thickness. Each zone has a voids in the range of about 20% to about 50%, and a pore size of about 10 nm to about 20 nm.

### EXAMPLE 2

This example demonstrates the preparation and describes the structure of an asymmetric microporous nylon membrane with charged continuous zones according to an embodiment of the invention, wherein the upstream zone has a positively charged continuous zone.

Three solutions (A, B, and C) are prepared. Solution A (positive charge) consists of 13% Nylon, 11% water, 1% Kymene, and 75% Formic Acid. Solution B (neutral charge) consists of 13% Nylon, 12% DI water, and 75% Formic Acid. Solution C (negative charge) consists of 13% Nylon, 11% DI water, 1% Gantrez, and 75% Formic Acid. The solutions are dissolved at 40 °C and deaerated before casting. Solutions A, B, and C are placed in knives 1, 2, and 3, respectively. Following casting, the membranes are quenched in a bath (1:2 mix of formic acid to DI water at room temperature) for about 6 minutes until the membrane is coagulated.

The membrane is about 225 µm in thickness, wherein each zone is about 75 µm in thickness. The upstream zone (positively charged continuous zone) comprises an asymmetric structure including a skin, wherein the skin has a thickness of about 2 µm to about 3 µm, with a graded void volume ranging from about 1% (at the surface) to about 3%, and having a graded pore size ranging from about 2 nm to about 10 nm. The upstream zone (below the skin, in the direction of the bulk) has a region of about 2 µm to about 5 µm in thickness with a voids volume ranging from about 2% to about 20%, and a pore size ranging from about 20 nm to about 400 nm. The remaining portion of the upstream zone has a voids volume ranging from about 20% to about 40%, and a pore size ranging from about 500 nm to about 800 nm.

The middle zone (neutral charge continuous zone) has a voids volume ranging from about 20% to about 40%, and a pore size ranging from about 500 nm to about 1500 nm (average 1200 nm). The bottom zone (negatively charged continuous zone) has a voids volume ranging from about 20% to about 55%, and a pore size ranging from about 1000 nm to about 1600 nm (average 1300 nm). Based on surface SEM analysis, the asymmetry ratio of the downstream surface to the upstream (skin) surface is 1:20.

### EXAMPLE 3

This example demonstrates the preparation and describes the structure of an asymmetric microporous nylon membrane with charged continuous zones according to an embodiment of the invention, wherein the upstream zone has a negatively charged continuous zone.

Three solutions (A, B, and C) are prepared. Solution A (negative charge) consists of 13% Nylon, 11% water, 1% Gantrez, and 75% Formic Acid. Solution B (neutral charge) consists of 13% Nylon, 12% DI water, and 75% Formic Acid. Solution C (positive charge) consists of 13% Nylon, 11% DI water, 1% Kymene, and 75% Formic Acid. The solutions are dissolved at 40 °C and deaerated before casting. Solutions A, B, and C are placed in knives 1, 2, and 3, respectively. Following casting, the membranes are quenched in a bath (1:2 mix of formic acid to DI water at room temperature) for about 6 minutes until the membrane is coagulated.

The membrane is about 225 µm in thickness, wherein each zone is about 75 µm in thickness. The upstream zone (negatively charged continuous zone "A") comprises an asymmetric structure including a skin, wherein the skin has a thickness of about 2 µm to about 3 µm, with a graded void volume ranging from about 1% (at the surface) to about 3%, and having a graded pore size ranging from about 2 nm to about 10 nm. The upstream zone (below the skin, in the direction of the bulk) has a region of about 2 µm to about 5 µm in thickness with a voids volume ranging from about 2% to about 20%, and a pore size ranging from about 20 nm to about 400 nm. The remaining portion of the upstream zone has a voids volume ranging from about 20% to about 40%, and a pore size ranging from about 500 nm to about 800 nm.

The middle zone (neutral charge continuous zone "B") has a voids volume ranging from about 20% to about 40%, and a pore size ranging from about 500 nm to about 1500 nm (average 1200 nm). The bottom zone (positively charged continuous zone "C") has a voids volume ranging from about 20% to about 55%, and a pore size ranging from about 1000 nm to about 1600 nm (average 1300 nm). Based on surface SEM analysis, the asymmetry ratio of the downstream surface to the upstream (skin) surface is 1:20.

As shown in Figure 2, the continuous zones are arranged generally parallel to the first and second microporous surfaces, wherein the neutral continuous zone "B" is interposed between the first charge continuous zone "A" and the second charge continuous zone "C." The first charge continuous zone "A" is negatively charged and the second charge continuous zone "C" is positively charged, and thus these zones have opposing charges. Additionally, the membrane has a portion where the negatively charged continuous zone contacts the neutral charge continuous zone (where "A" contacts "B"), and a portion where the positively charged continuous zone contacts the neutral continuous zone (where "B" contacts "C"), wherein the portions are arranged generally parallel to each other.

### EXAMPLE 4

This example demonstrates the membrane prepared as described above in Example 1 has continuous zones of negative charge and positive charge, separated by a zone of neutral charge.

Membranes are produced as described in Example 1.

A membrane is submerged for 30 minutes in a negatively charged dye solution (Ponseau Red Dye, 0.05% in DI water). The membrane is leached in a 0.1% solution of ammonium hydroxide, followed by DI water leaching and drying. Digital microscope photos shown the red color dye is present in the surface of the membrane having the positive charge.

A membrane is submerged for 30 minutes in a positively charged dye solution (Toluidine Blue Dye, 0.05% in DI water). The membrane is leached DI water, followed by drying. Digital microscope photos shown the blue color dye is present in the surface of the membrane having the negative charge.

Dye is not present in the middle thickness of the membranes, as these portions of the membranes (the neutral continuous zones) are not charged.

### EXAMPLE 5

This example demonstrates the preparation of isometric and asymmetric polyethersulfone membranes according to other embodiments of the invention.

Three solutions (A, B, and C) are prepared. Solution A (positive charge) consists of 11.5% polyethersulfone (PES), 5% DI water, 0.5% Kymene, 3% polyvinylpyrrolidone (PVP) (K-90); 25% polyethylene glycol 200 (PEG200), and 55% N-methyl pyrrolidone (NMP). Solution B (neutral charge) consists of 12% PES, 5% DI water, 3% PVP (K-90); 25% polyethylene glycol 200 (PEG200), and 55% N-methyl pyrrolidone (NMP).

Solution C (negative charge) consists of 11.5% polyethersulfone (PES), 5% DI water, 0.5% Gantrez, 3% polyvinylpyrrolidone (PVP) (K-90); 25% polyethylene glycol 200 (PEG200), and 55% N-methyl pyrrolidone (NMP).

The solutions are dissolved at 30 °C and deaerated before casting.

For membranes wherein the upstream zone has a positively charged continuous zone, solutions A, B, and C are placed in knives 1, 2, and 3, respectively. For membranes wherein the upstream zone has a negatively charged continuous zone, solutions C, B, and A are placed in knives 1, 2, and 3, respectively.

In producing asymmetric membranes, the cast solutions are quenched within about 4 seconds, in a DI water bath at 105 °F for about 6 minutes until the membrane is coagulated.

In producing isometric membranes, the cast solutions are quenched after about 25 seconds, in a DI water bath at room temperature for about 6 minutes until the membrane is coagulated.

The continuous zones are arranged generally parallel to the first and second microporous surfaces, wherein the neutral continuous zone is interposed between the first charge continuous zone and the second charge continuous zone, wherein the first charge continuous zone and the second charge continuous zone have opposing charges.

### EXAMPLE 6

This example demonstrates the preparation of an isometric templated membrane according to an embodiment of the invention, and the upstream zone has a positively charged continuous zone.

An embossed polypropylene substrate template (BP100P, 5.0 mils; Bloomer Plastics Inc., Bloomer, WI), is obtained.

Three solutions (A, B, and C) are prepared. Solution A (positive charge) consists of 13% Nylon, 11% water, 1% Kymene, and 75% Formic Acid. Solution B (neutral charge) consists of 13% Nylon, 12% water, and 75% Formic Acid. Solution C (negative charge) consists of 13% Nylon, 11% water, 1% Gantrez, and 75% Formic Acid. The solutions are dissolved at 40 °C and deaerated before casting. Solutions A, B, and C are placed in knives 1, 2, and 3, respectively.

The solutions are cast on the pretreated embossed polypropylene substrate.

Following casting, the membrane is quenched in a bath (1:1 mix of formic acid to deionized water at room temperature) for about 6 minutes until the membrane is coagulated.

The membrane is leached, separated from the template, and dried.

The first microporous surface (the "templated surface") comprises a first region (a raised portion) and a second region (a depressed "valley" portion), and the distance between the first region of the first microporous surface and the second microporous surface is about 15 percent greater than the distance between the second region of the first microporous surface and the second microporous surface. The pore size in both the first and second regions of the first surface are in the range of from about 1000 nm to about 2000 nm.

### EXAMPLE 7

This example demonstrates the preparation of an asymmetric templated membrane according to an embodiment of the invention, wherein the upstream zone has a positively charged continuous zone.

An embossed polypropylene substrate template (BP100P, 5.0 mils; Bloomer Plastics Inc., Bloomer, WI), is obtained.

Three solutions (A, B, and C) are prepared. Solution A (positive charge) consists of 13% Nylon, 11% water, 1% Kymene, and 75% Formic Acid. Solution B (neutral charge) consists of 13% Nylon, 12% water, and 75% Formic Acid. Solution C (negative charge) consists of 13% Nylon, 11% water, 1% Gantrez, and 75% Formic Acid. The solutions are dissolved at 40 °C and deaerated before casting. Solutions A, B, and C are placed in knives 1, 2, and 3, respectively.

The solutions are cast on the pretreated embossed polypropylene substrate.

Following casting, the membrane is quenched in a bath (1:2 mix of formic acid to deionized water at room temperature) for about 6 minutes until the membrane is coagulated.

The membrane is leached, separated from the template, and dried.

The membrane is about 225 µm in thickness, wherein each zone is about 75 µm in thickness. The upstream zone (positively charged continuous zone) comprises an asymmetric structure including a skin, wherein the skin has a thickness of about 2 µm to about 3 µm, with a graded void volume ranging from about 1% (at the surface) to about 3%, and having a graded pore size ranging from about 2 nm to about 10 nm. The upstream zone (below the skin, in the direction of the bulk) has a region of about 2 µm to about 5 µm in thickness with a voids volume ranging from about 2% to about 20%, and a pore size ranging from about 20 nm to about 400 nm. The remaining portion of the upstream zone has a voids volume ranging from about 20% to about 40%, and a pore size ranging from about 500 nm to about 800 nm.

The middle zone (neutral charge continuous zone) has a voids volume ranging from about 20% to about 40%, and a pore size ranging from about 500 nm to about 1500 nm (average 1200 nm). The bottom zone (negatively charged continuous zone) has a voids volume ranging from about 20% to about 55%, and a pore size ranging from about 1000 nm to about 1600 nm (average 1300 nm). Based on surface SEM analysis, the asymmetry ratio of the downstream surface to the upstream (skin) surface is 1:20.

As shown in Figure 3, the first microporous surface (the "templated surface") comprises a first region and a second region, and the distance between the first region of the first microporous surface and the second microporous surface is about 15 percent greater than the distance between the second region of the first microporous surface and the second microporous surface. Additionally, the membrane has a portion where the positively charged continuous zone contacts the neutral charge continuous zone (where "A" contacts "B"), and a portion where the negatively charged continuous zone contacts the neutral continuous zone (where "B" contacts "C"), wherein the portions are arranged generally parallel to each other.

The use of the terms "a" and "an" and "the" and "at least one" and similar referents in the context of describing the invention (especially in the context of the following claims) are to be construed to cover both the singular and the plural, unless otherwise indicated herein or clearly contradicted by context. The use of the term "at least one" followed by a list of one or more items (for example, "at least one of A and B") is to be construed to mean one item selected from the listed items (A or B) or any combination of two or more of the listed items (A and B), unless otherwise indicated herein or clearly contradicted by context. The terms "comprising," "having," "including," and "containing" are to be construed as open-ended terms (i.e., meaning "including, but not limited to,") unless otherwise noted. All methods described herein can be performed in any suitable order unless otherwise indicated herein or otherwise clearly contradicted by context.

## Claims

1. A microporous polyamide or polysulfone membrane comprising a single layer having
- a first microporous surface;
- a second microporous surface; and,
- a bulk between the first microporous surface and the second microporous surface, wherein the bulk has a first charge continuous zone, a neutral charge continuous zone, and a second charge continuous zone, the continuous zones arranged generally parallel to the first and second microporous surfaces,
wherein the neutral continuous zone is interposed between the first charge continuous zone and the second charge continuous zone, and wherein the first charge continuous zone and the second charge continuous zone have opposing charges;
said membrane being obtainable in a method comprising
(a) preparing a polymeric solution comprising a positive charge;
(b) preparing a polymeric solution comprising a neutral charge;
(c) preparing a polymeric solution comprising a negative charge;
(d) casting the solutions sequentially on a moving support, wherein said polymeric solutions are either all polyamide solutions or all polysulfone solutions, and wherein
(i) either the polymeric solution comprising the positive charge, or the polymeric solution comprising the negative charge, is cast first, forming a pre-membrane;
(ii) the polymeric solution comprising the neutral charge is cast second, onto the pre-membrane;
(iii) the polymeric solution comprising the positive charge or the polymeric solution comprising the negative charge that is not cast in (i) is cast third, onto the polymeric solution comprising the neutral charge; and,
(e) subsequently effecting phase separation of the solutions in a nonsolvent liquid.

2. The membrane of claim 1, wherein the first charge continuous zone extends from the first microporous surface into the bulk, and the first charge continuous zone is a positively charged zone, and the second charge continuous zone extends from the second microporous surface into the bulk, and the second charge continuous zone is a negatively charged zone.

3. The membrane of claim 1, wherein the first charge continuous zone extends from the first microporous surface into the bulk, and the first charge continuous zone is a negatively charged zone, and the second charge continuous zone extends from the second microporous surface into the bulk, and the second charge continuous zone is a positively charged zone.

4. The membrane of any one of claims 1 to 3, wherein said single layer is an isometric membrane.

5. The membrane of any one of claims 1 to 3, wherein said single layer is an asymmetric membrane.

6. The membrane of claim 2, wherein said single layer is an asymmetric membrane, having a mean pore size decreasing in size from the first microporous surface and positively charged zone toward the second microporous surface and negatively charged zone.

7. The membrane of any one of claims 1 to 6, wherein the first microporous surface comprises a templated surface.

8. The membrane of claim 7, wherein the first microporous surface comprises a first region and a second region, and the distance between the first region of the first microporous surface and the second microporous surface is about 10% greater than the distance between the second region of the first microporous surface and the second microporous surface.

9. A method of treating a fluid, the method comprising passing the fluid through the membrane of any one of claims 1 to 8.

10. The method of claim 9, comprising filtering a photoresist fluid.

11. The method of claim 10 wherein the photoresist fluid is passed through the membrane of claim 2 or claim 6.

12. The method of claim 11, wherein said single layer is a polyamide membrane.

## Patentansprüche

1. Mikroporöse Polyamid- oder Polysulfon-Membran, umfassend eine einzelne Lage mit
- einer ersten mikroporösen Oberfläche;
- einer zweiten mikroporösen Oberfläche; und
- einem Volumen zwischen der ersten mikroporösen Oberfläche und der zweiten mikroporösen Oberfläche, wobei das Volumen eine kontinuierliche Zone mit einer ersten Ladung, eine kontinuierliche Zone mit einer neutralen Ladung und eine kontinuierliche Zone mit einer zweiten Ladung aufweist, wobei die kontinuierlichen Zonen im Wesentlichen parallel zu der ersten und zweiten mikroporösen Oberfläche angeordnet sind,
wobei die neutrale kontinuierliche Zone zwischen der kontinuierlichen Zone mit der ersten Ladung und der kontinuierlichen Zone mit der zweiten Ladung angeordnet ist und wobei die kontinuierliche Zone mit der ersten Ladung und die kontinuierliche Zone mit der zweiten Ladung entgegengesetzte Ladungen aufweisen;
wobei die Membran erhältlich ist nach einem Verfahren, welches umfasst:
(a) Herstellen einer polymeren Lösung, welche eine positive Ladung umfasst;
(b) Herstellen einer polymeren Lösung, welche eine neutrale Ladung umfasst;
(c) Herstellen einer polymeren Lösung, welche eine negative Ladung umfasst;
(d) Vergießen der Lösungen nacheinander auf einer bewegten Unterlage, wobei die polymeren Lösungen entweder alle Polyamid-Lösungen sind oder alle Polysulfon-Lösungen sind und wobei
(i) entweder die polymere Lösung, welche die positive Ladung umfasst, oder die polymere Lösung, welche die negative Ladung umfasst, zuerst vergossen wird, so dass eine Vormembran gebildet wird;
(ii) die polymere Lösung, welche die neutrale Ladung umfasst, als zweites auf der Vormembran vergossen wird;
(iii) die polymere Lösung, welche die positive Ladung umfasst, oder die polymere Lösung, welche die negative Ladung umfasst, die in Schritt (i) nicht vergossen wird, als drittes auf der polymeren Lösung, welche die neutrale Ladung umfasst, vergossen wird; und,
(e) im Anschluss daran, Bewirken einer Phasentrennung der Lösungen in einem Nicht-Lösemittel.

2. Membran nach Anspruch 1, wobei die kontinuierliche Zone mit der ersten Ladung sich von der ersten mikroporösen Oberfläche in das Volumen hinein erstreckt und die kontinuierliche Zone mit der ersten Ladung eine positiv geladene Zone ist und wobei die kontinuierliche Zone mit der zweiten Ladung sich von der zweiten mikroporösen Oberfläche in das Volumen hinein erstreckt und die kontinuierliche Zone mit der zweiten Ladung eine negativ geladene Zone ist.

3. Membran nach Anspruch 1, wobei die kontinuierliche Zone mit der ersten Ladung sich von der ersten mikroporösen Oberfläche in das Volumen hinein erstreckt und die kontinuierliche Zone mit der ersten Ladung eine negativ geladene Zone ist und wobei die kontinuierliche Zone mit der zweiten Ladung sich von der zweiten mikroporösen Oberfläche in das Volumen hinein erstreckt und die kontinuierliche Zone mit der zweiten Ladung eine positiv geladene Zone ist.

4. Membran nach einem der Ansprüche 1 bis 3, wobei die einzelne Lage eine isometrische Membran ist.

5. Membran nach einem der Ansprüche 1 bis 3, wobei die einzelne Lage eine asymmetrische Membran ist.

6. Membran nach Anspruch 2, wobei die einzelne Lage eine asymmetrische Membran ist, welche eine mittlere Porengröße aufweist, die ausgehend von der ersten mikroporösen Oberfläche und der positiv geladenen Zone zu der zweiten mikroporösen Oberfläche und der negativ geladenen Zone hin in der Größe abnimmt.

7. Membran nach einem der Ansprüche 1 bis 6, wobei die erste mikroporöse Oberfläche eine mittels eines Templatverfahrens behandelte Oberfläche umfasst.

8. Membran nach Anspruch 7, wobei die erste mikroporöse Oberfläche einen ersten Bereich und einen zweiten Bereich umfasst und wobei der Abstand zwischen dem ersten Bereich der ersten mikroporösen Oberfläche und der zweiten mikroporösen Oberfläche ungefähr 10 % größer ist als der Abstand zwischen dem zweiten Bereich der ersten mikroporösen Oberfläche und der zweiten mikroporösen Oberfläche.

9. Verfahren zum Behandeln eines Fluids, wobei das Verfahren ein Durchleiten des Fluids durch die Membran nach einem der Ansprüche 1 bis 8 umfasst.

10. Verfahren nach Anspruch 9, welches ein Filtern eines Photoresistfluids umfasst.

11. Verfahren nach Anspruch 10, wobei das Photoresistfluid durch die Membran nach Anspruch 2 oder Anspruch 6 hindurch geleitet wird.

12. Verfahren nach Anspruch 11, wobei die einzelne Lage eine PolyamidMembran ist.

## Revendications

1. Membrane de polyamide ou polysulfone microporeuse comprenant une couche unique présentant
- une première surface microporeuse ;
- une seconde surface microporeuse ; et,
- un volume entre la première surface microporeuse et la seconde surface microporeuse, dans laquelle le volume présente une zone continue de première charge, une zone continue de charge neutre, et une zone continue de seconde charge, les zones continues disposées généralement parallèles aux première et seconde surfaces microporeuses,
dans laquelle la zone continue neutre est intercalée entre la zone continue de première charge et la zone continue de seconde charge, et dans laquelle la zone continue de première charge et la zone continue de seconde charge présentent des charges opposées ;
ladite membrane pouvant être obtenue dans un procédé comprenant
(a) la préparation d'une solution polymère comprenant une charge positive ;
(b) la préparation d'une solution polymère comprenant une charge neutre ;
(c) la préparation d'une solution polymère comprenant une charge négative ;
(d) la coulée des solutions successivement sur un support en déplacement, dans laquelle
lesdites solutions polymères sont soit toutes des solutions de polyamide, soit toutes des solutions de polysulfone, et dans laquelle
(i) soit la solution polymère comprenant la charge positive, soit la solution polymère comprenant la charge négative, est coulée en premier, formant une pré-membrane ;
(ii) la solution polymère comprenant la charge neutre est coulée en deuxième, sur la pré-membrane ;
(iii) la solution polymère comprenant la charge positive ou la solution polymère comprenant la charge négative qui n'est pas coulée dans (i) est coulée en troisième, sur la solution polymère comprenant la charge neutre ; et,
(e) ensuite la réalisation d'une séparation de phases des solutions dans un liquide de non-solvant.

2. Membrane selon la revendication 1, dans laquelle la zone continue de première charge s'étend à partir de la première surface microporeuse dans le volume, et la zone continue de première charge est une zone positivement chargée, et la zone continue de seconde charge s'étend à partir de la seconde surface microporeuse dans le volume, et la zone continue de seconde charge est une zone négativement chargée.

3. Membrane selon la revendication 1, dans laquelle la zone continue de première charge s'étend à partir de la première surface microporeuse dans le volume, et la zone continue de première charge est une zone négativement chargée, et la zone continue de seconde charge s'étend à partir de la seconde surface microporeuse dans le volume, et la zone continue de seconde charge est une zone positivement chargée.

4. Membrane selon l'une quelconque des revendications 1 à 3, dans laquelle ladite couche unique est une membrane isométrique.

5. Membrane selon l'une quelconque des revendications 1 à 3, dans laquelle ladite couche unique est une membrane asymétrique.

6. Membrane selon la revendication 2, dans laquelle ladite couche unique est une membrane asymétrique, présentant une taille moyenne de pore diminuant en taille à partir des première surface microporeuse et zone positivement chargée vers les seconde surface microporeuse et zone négativement chargée.

7. Membrane selon l'une quelconque des revendications 1 à 6, dans laquelle la première surface microporeuse comprend une surface à modèle.

8. Membrane selon la revendication 7, dans laquelle la première surface microporeuse comprend une première région et une seconde région, et la distance entre la première région de la première surface microporeuse et la seconde surface microporeuse est d'environ 10 % supérieure à la distance entre la seconde région de la première surface microporeuse et la seconde surface microporeuse.

9. Procédé de traitement d'un fluide, le procédé comprenant le passage du fluide à travers la membrane selon l'une quelconque des revendications 1 à 8.

10. Procédé selon la revendication 9, comprenant la filtration d'un fluide de photorésist.

11. Procédé selon la revendication 10, dans lequel le fluide de photorésist passe à travers la membrane selon la revendication 2 ou la revendication 6.

12. Procédé selon la revendication 11, dans lequel ladite couche unique est une membrane de polyamide.
